# FASCICULE DE BREVET EUROPEEN

(11) **EP 3 836 374 B1**
(45) Date de publication et mention de la délivrance du brevet: **13.11.2024**
(21) Numéro de dépôt: 20212972.2
(22) Date de dépôt: 10.12.2020
(51) Int. Cl.: H02M 1/08, H02M 1/38, H02M 7/02, H02M 7/12, H02M 7/162, H02M 7/219, H03K 17/13, H03K 17/082, H03K 17/16, H02M 7/217, H02M 1/00, H02M 3/335

(54) **DISPOSITIF ÉLECTRONIQUE POUR LA COMMANDE D'UN INTERRUPTEUR BIDIRECTIONNEL**
ELEKTRONISCHES GERÄT ZUR STEUERUNG EINES BIDIREKTIONALEN SCHALTERS
ELECTRONIC DEVICE FOR THE CONTROL OF A BIDIRECTIONAL SWITCH

(30) Priorité: 13.12.2019 FR 1914394
(43) Date de publication de la demande: 16.06.2021
(73) Titulaire: Commissariat à l'Energie Atomique et aux Energies Alternatives, 75015 Paris (FR)
(72) Inventeur: STERNA, Léo, 38054 GRENOBLE CEDEX 9 (FR); PERICHON, Pierre, 38054 GRENOBLE CEDEX 9 (FR)
(74) Mandataire: Cabinet Beaumont

(56) Documents cités:
- FR-A1- 2 866 492
- FR-B1- 2 866 492
- US-A1- 2007 007 912
- US-A1- 2018 198 380

## Description

### Domaine technique

La présente description concerne de façon générale les dispositifs électroniques, en particulier les convertisseurs à découpage.

### Technique antérieure

Les convertisseurs à découpage utilisent un ou des interrupteurs mis alternativement aux états passant et bloqué à une fréquence de découpage. On utilise des convertisseurs à découpage pour fournir une tension et/ou un courant à partir d'une alimentation ayant des valeurs de tension/courant différentes des valeurs des tension/courant à fournir. Par exemple, un convertisseur à découpage de type alternatif-continu AC-DC (en anglais "Alternating-Direct") permet d'obtenir une tension continue à partir d'une tension alternative telle que celle d'un réseau électrique ou d'un alternateur. FR 2866492 A1, US 2007/007912 A1 et US 2018/198380 A1 divulguent des circuits de commande avec des interrupteurs bidirectionnels.

### Résumé de l'invention

Il existe un besoin de réduire l'encombrement des convertisseurs connus.

Il existe un besoin d'augmenter le rendement énergétique et de réduire l'échauffement des convertisseurs connus.

Conformément à la présente invention, un appareil, selon la revendication 1 et un procédé de commande de l'appareil, selon la revendication 10 sont fournis. Des modes de réalisation préférés de l'invention sont revendiqués dans les revendications dépendantes.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1 représente, de manière schématique, un exemple de convertisseur à découpage d'un type auquel s'appliquent les modes de réalisation décrits ;
la figure 2 représente, par une vue en coupe schématique, un exemple d'interrupteur bidirectionnel d'un type auquel s'appliquent les modes de réalisation décrits ;
la figure 3 représente, de manière schématique, un mode de réalisation d'un dispositif comprenant un circuit de commande et des interrupteurs électriquement en série ;
la figure 4 représente, de manière schématique, un mode de réalisation d'une branche de convertisseur ;
la figure 5 représente, par des chronogrammes schématiques, un mode de réalisation d'un procédé mis en oeuvre par la branche de la figure 4 ;
la figure 6 représente, de manière schématique, un mode de réalisation d'un capteur du dispositif de la figure 3 ; et
la figure 7 représente, de manière schématique, un mode de réalisation d'un circuit logique du dispositif de la figure 3.

### Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés. En particulier, un circuit d'attaque (en anglais "driver"), prévu pour appliquer une commande à un interrupteur bidirectionnel, n'est pas décrit en détail, les modes de réalisation décrits étant compatibles avec les circuits d'attaque usuels.

Sauf précision contraire, lorsque l'on fait référence à deux éléments connectés entre eux, cela signifie directement connectés sans éléments intermédiaires autres que des conducteurs, et lorsque l'on fait référence à deux éléments reliés (en anglais "coupled") entre eux, cela signifie que ces deux éléments peuvent être connectés ou être reliés par l'intermédiaire d'un ou plusieurs autres éléments.

Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence sauf précision contraire à l'orientation des figures.

Sauf précision contraire, les expressions "environ", "approximativement", "sensiblement", et "de l'ordre de" signifient à 10 % près, de préférence à 5 % près.

Sauf précision contraire, les adjectifs numéraux ordinaux, tels que "premier", "deuxième", etc., sont utilisés seulement pour distinguer des éléments entre eux. En particulier, ces adjectifs ne limitent pas les dispositifs et procédés décrits à un ordre particulier de ces éléments.

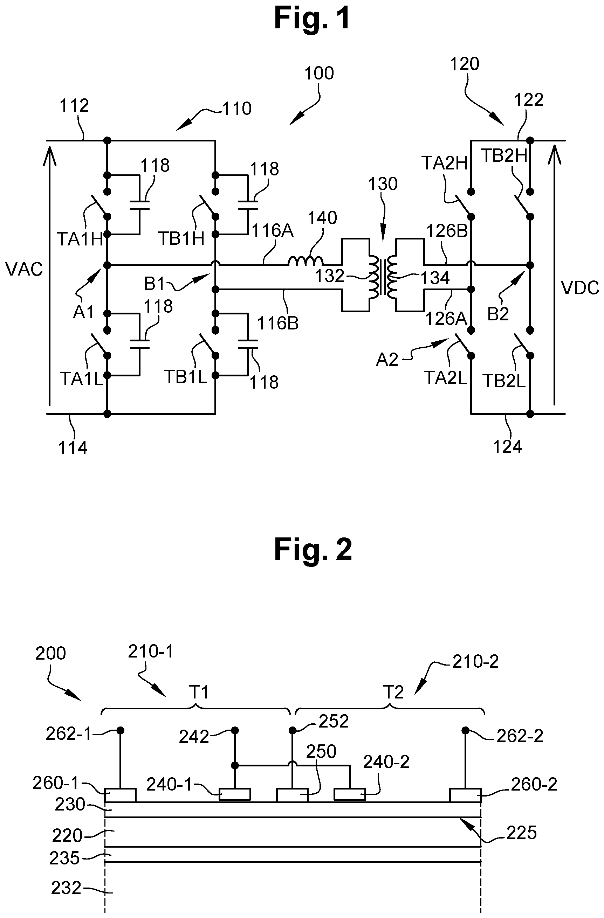

La figure 1 représente, de manière schématique, un exemple de convertisseur à découpage 100 d'un type auquel s'appliquent les modes de réalisation décrits. Dans cet exemple particulier, le convertisseur 100 est identique ou similaire aux convertisseurs décrits dans la demande de brevet EP3346598 (B15653-DD17624).

Le convertisseur 100 est un convertisseur de type AC-DC, recevant une tension alternative VAC et fournissant une tension continue VDC. Dans une application typique, la tension alternative VAC provient d'un réseau de distribution électrique, et a par exemple une tension efficace de l'ordre de 110 V ou d'environ 230 V, et par exemple une fréquence égale à 50 Hz ou 60 Hz. La tension alternative VAC est ainsi, de préférence, une tension élevée, c'est-à-dire de valeur crête supérieure à 100 V, de préférence supérieure à 300 V, par exemple égale à environ 450 V ou à environ 600 V.

La tension continue est typiquement utilisée pour charger une batterie, par exemple une batterie d'un ordinateur portable ou d'un dispositif mobile de communication à distance tel qu'un téléphone mobile. Dans une application, la tension continue est fournie par l'intermédiaire d'une prise selon le standard de bus universel en série USB (en anglais "Universal Serial Bus"), par exemple de type C, préférentiellement au standard de livraison d'énergie PD (en anglais "Power Delivery"). La tension continue VDC est alors de 5 V, 12 V ou 20 V. La puissance délivrée peut alors aller jusqu'à 100 W. Dans d'autres applications, la batterie est celle d'un onduleur, par exemple du type utilisé dans les centres de données (en anglais "data center"). La puissance peut alors être supérieure à 1 kW, par exemple d'environ 1,5 kW.

Le convertisseur 100 comprend quatre interrupteurs TA1H, TA1L, TB1H, TB1L, par exemple identiques à des dispersions de fabrication près. Les interrupteurs TA1H, TA1L, TB1H, TB1L sont connectés de manière à former un premier pont en H 110. Le premier pont en H 110 comprend deux branches A1 et B1 reliant des noeuds 112 et 114 d'application de la tension alternative VAC. La branche A1 comprend les interrupteurs TA1H et TA1L électriquement en série entre les noeuds 112 et 114. La branche B1 comprend les interrupteurs TB1H et TB1L électriquement en série entre les noeuds 112 et 114. Les interrupteurs TA1H et TB1H sont situés du côté du noeud 112 et les interrupteurs TA1L et TB1L sont situés du côté du noeud 114. Le pont en H 110 comprend un noeud 116A de connexion entre les interrupteurs TA1H et TA1L et un noeud 116B de connexion entre les interrupteurs TB1H et TB1L. Le premier pont en H 110 comprend en outre, électriquement en parallèle de chaque interrupteur TA1H, TA1L, TB1H, TB1L, un élément capacitif 118. Les éléments capacitifs 118 peuvent être des condensateurs ou, par exemple, des capacités internes aux interrupteurs, telles que des capacités apparaissant entre des régions semiconductrices de chaque interrupteur.

Le convertisseur 100 comprend en outre quatre interrupteurs TA2H, TA2L, TB2H, TB2L, par exemple identiques à des dispersions de fabrication près. Les interrupteurs TA2H, TA2L, TB2H, TB2L sont connectés de manière à former un deuxième pont en H 120. Le deuxième pont en H 120 comprend deux branches A2 et B2 reliant des noeuds 122 et 124 de fourniture de la tension continue VDC. La branche A2 comprend les interrupteurs TA2H et TA2L électriquement en série entre les noeuds 122 et 124. La branche B2 comprend les interrupteurs TB2H et TB2L électriquement en série entre les noeuds 122 et 124. Les interrupteurs TA2H et TB2H sont situés du côté du noeud 122 et les interrupteurs TA2L et TB2L sont situés du côté du noeud 124. Le pont en H 120 comprend un noeud 126A de connexion entre les interrupteurs TA2H et TA2L et un noeud 126B de connexion entre les interrupteurs TB2H et TB2L.

Le convertisseur 100 comprend en outre un transformateur 130. Le transformateur 130 a un premier enroulement 132 électriquement en série avec une inductance 140 entre les noeuds 116A et 116B du premier pont en H 110. Le transformateur 130 a un deuxième enroulement 134 reliant, de préférence connectant, les noeuds 126A et 126B du deuxième pont en H 120. En variante, le premier enroulement 132 connecte les noeuds 116A et 116B, et l'inductance 140 est en série avec le deuxième enroulement 134 entre les noeuds 126A et 126B.

En fonctionnement, la tension alternative prend successivement des valeurs positives (potentiel du noeud 112 supérieur à celui du noeud 114) et négatives (potentiel du noeud 112 inférieur à celui du noeud 114). Pour assurer ce fonctionnement, les interrupteurs TA1H, TA1L, TB1H, TB1L sont bidirectionnels en tension. Un interrupteur bidirectionnel en tension est défini par un interrupteur apte, à un état bloqué, à empêcher le passage d'un courant pour les deux sens de la tension aux bornes de l'interrupteur. En outre, le courant circulant dans l'inductance 140 est également alternatif. Pour cela, les interrupteurs sont bidirectionnels en courant. Un interrupteur bidirectionnel en courant est défini par un interrupteur apte, à un état passant, à permettre le passage d'un courant dans les deux sens. Ainsi, les interrupteurs TA1H, TA1L, TB1H, TB1L sont bidirectionnels en tension et en courant.

Dans un exemple de fonctionnement, à une fréquence de découpage, on rend alternativement les interrupteurs TA1H et TB1L passants et TB1H et TA1L bloqués, puis TA1H et TB1L bloqués et TB1H et TA1L passants. Cet exemple n'est pas limitatif, les procédés de commande des divers interrupteurs du convertisseur 100 pour obtenir, grâce au découpage, la tension VDC à partir de la tension VAC ne sont pas décrits en détail, les modes de réalisation décrits étant compatibles avec les procédés usuels de commande d'interrupteurs de convertisseur AC-DC à découpage. La fréquence de découpage est plus élevée que celle de la tension alternative VAC, de préférence supérieure à 1 MHz.

Dans le convertisseur 100, afin d'éviter des pertes d'énergie dans les interrupteurs TA1H, TA1L, TB1H, TB1L lors des commutations entre l'état passant et l'état bloqué, chaque commutation entre l'état bloqué et l'état passant d'un interrupteur TA1H, TA1L, TB1H, TB1L est effectuée lorsque la tension aux bornes de l'interrupteur s'annule, ou s'annule sensiblement par rapport à la valeur crête de la tension VAC. De telles commutations sont appelées commutation à tension nulle ZVS (en anglais "Zéro Volt Switching").

L'exemple du convertisseur 100 décrit ci-dessus n'est pas limitatif. En particulier, les modes de réalisation décrits sont applicables à tout convertisseur similaire au convertisseur 100 destiné à recevoir et/ou fournir une tension alternative. Les modes de réalisation décrits sont également applicables à tout convertisseur à découpage, en particulier à tout convertisseur destiné à recevoir et/ou fournir une tension ayant des signes successifs différents, préférentiellement une tension alternative monophasée ou multiphasée. En particulier, les modes de réalisation sont applicables à tout convertisseur comprenant une ou plusieurs branches entre deux noeuds d'application de la tension alternative. Chaque branche comprend alors au moins deux interrupteurs en série. Les branches fournissent typiquement un courant à une inductance interne au convertisseur. De préférence, les interrupteurs de chaque branche sont commandés en ZVS, et, plus préférentiellement, ces interrupteurs sont bidirectionnels. Par bidirectionnel, on entend bidirectionnel en courant et/ou en tension.

La figure 2 représente, par une vue en coupe schématique, un exemple d'interrupteur bidirectionnel 200 d'un type auquel s'appliquent les modes de réalisation décrits. L'interrupteur bidirectionnel 200 peut constituer tout interrupteur bidirectionnel d'un convertisseur à découpage. Par exemple les interrupteurs TA1H, TB1H, TA1L et TB1L du convertisseur 100 de la figure 1 sont chacun identique ou similaire à l'interrupteur bidirectionnel 200.

L'interrupteur bidirectionnel 200 comprend deux interrupteurs 210-1 et 210-2 électriquement en série. Les interrupteurs 210-1 et 210-2 comprennent des transistors à effet de champ respectifs T1 et T2. Les transistors T1 et T2 peuvent alors être de tout type à effet de champ. Cependant, préférentiellement, les transistors T1 et T2 sont du type représenté, dit transistor à haute mobilité électronique, HEMT (de l'anglais "High Electron-Mobility Transistor"). De tels transistors comprennent deux couches semiconductrices 220 et 230 en contact l'une avec l'autre, les couches semiconductrices 220 et 230 définissant alors entre elles une interface 225. Les électrons sont mobiles le long de l'interface 225. Un tel transistor permet de bloquer des tensions plus élevées et permet des commutations plus rapides que d'autres types de transistors à effet de champ. Plus préférentiellement, les semiconducteurs des couches 220 et 230 sont respectivement du nitrure de Gallium (GaN) et du nitrure d'aluminium-gallium (AlGaN). On parle alors de transistor de type HEMT à GaN.

Les couches 220 et 230 reposent typiquement sur un support 232. Le support 232 est par exemple une portion de tranche (en anglais "wafer") semiconductrice telle qu'une tranche de silicium. Le support 232 peut être recouvert de couches tampon 235 situées entre le support 232 et la couche 220, destinées à faciliter la formation de la couche 230 sur le support 232. Divers éléments, tels que des régions isolantes, ainsi que les matériaux autres que ceux décrits ci-dessus, et des dimensions telles que les épaisseurs des couches, ne sont pas détaillés ici, les modes de réalisation décrits étant compatibles avec les transistors HEMT à GaN usuels.

Bien que, dans l'exemple représenté, chaque interrupteur 210-1, 210-2 comprenne seulement un transistor, respectivement T1, T2, l'interrupteur 210-1 peut comprendre plusieurs transistors T1 électriquement en parallèle les uns des autres, et l'interrupteur 210-2 peut comprendre plusieurs transistors T2 électriquement en parallèle les uns des autres.

De préférence, plusieurs interrupteurs bidirectionnels 200 sont situés sur le même support 232. Ces interrupteurs bidirectionnels sont par exemple quatre interrupteurs d'un pont en H. Un tel pont en H, formé dans et/ou sur un même support, est dit monolithique. Les interrupteurs du pont en H sont alors, de préférence, situés dans un même boîtier de circuit intégré. Par boîtier de circuit intégré, on entend un ensemble, de préférence étanche, d'où sortent des plages de connexion ou des broches de connexion à des circuits électroniques extérieurs au boîtier, par exemple à un circuit imprimé, PCB (en anglais "Printed Circuit Board"). En variante, les interrupteurs sont dans et/ou sur des supports différents, par exemple dans un même boîtier. Dans une autre variante, les interrupteurs de chaque branche de pont en H sont dans un même boîtier.

Les transistors T1 et T2 comprennent chacun une grille, respectivement 240-1, 240-2, et une région de drain, respectivement 260-1, 260-2. Les transistors T1 et T2 comprennent chacun une borne, respectivement 262-1, 262-2 reliée, de préférence connectée, à la région de drain, respectivement 260-1, 260-2. Dans l'exemple représenté, les grilles et les régions de drain sont situées sur la couche 230.

L'interrupteur bidirectionnel 200 comprend une borne de source 252 commune aux transistors T1 et T2, connectée à une région de source 250 commune aux transistors T1 et T2. Dans l'exemple représenté, la région de source commune est située sur la couche 230. Dans chaque transistor T1, T2, la grille, respectivement 240-1, 240-2 est située entre la région de drain, respectivement 260-1, 260-2, et la région de source commune 250. Dans une variante, la borne de source 252 est reliée, par exemple connectée, à des régions de sources distinctes dans les transistors T1 et T2.

Chaque transistor T1, T2 est configuré pour que, lorsqu'une tension positive est appliquée entre le drain et la source du transistor, l'état passant/bloqué du transistor est commandé par la tension entre la grille et la source du transistor. Ainsi, en particulier lorsque la tension prend des valeurs élevées telles que définies ci-dessus, la majeure partie de cette tension est entre le drain et la grille.

De préférence, l'interrupteur bidirectionnel 200 comprend une borne commune 242 reliée, de préférence connectée, aux grilles 240-1 et 240-2 des transistors T1 et T2. La borne commune 242 constitue une borne de commande de l'interrupteur bidirectionnel 200. En variante, l'interrupteur bidirectionnel 200 a, pour chaque interrupteur 210-1, 210-2, une borne de commande distincte reliée, de préférence connectée, à la grille concernée. Cependant, par rapport à une telle variante, la borne commune présente l'avantage de nécessiter un seul signal pour commander l'état passant ou bloqué de l'interrupteur bidirectionnel, ce qui simplifie le procédé de commande de l'interrupteur bidirectionnel.

De préférence, comme ceci est représenté, les structures des interrupteurs 210-1 et 210-2 constituées par les couches 220 et 230, les grilles et les régions de drain et de source, sont symétriques l'une de l'autre par rapport à un plan ou par rapport à un axe passant par la région de source commune. Par symétrique, on entend symétrique à des dispersions de fabrication près. Ceci permet, par rapport à des interrupteurs 210-1 et 210-2 non symétriques, d'obtenir plus facilement dans et/ou sur un même support 232 plusieurs interrupteurs bidirectionnels 200 à région de source commune ayant des caractéristiques électriques identiques.

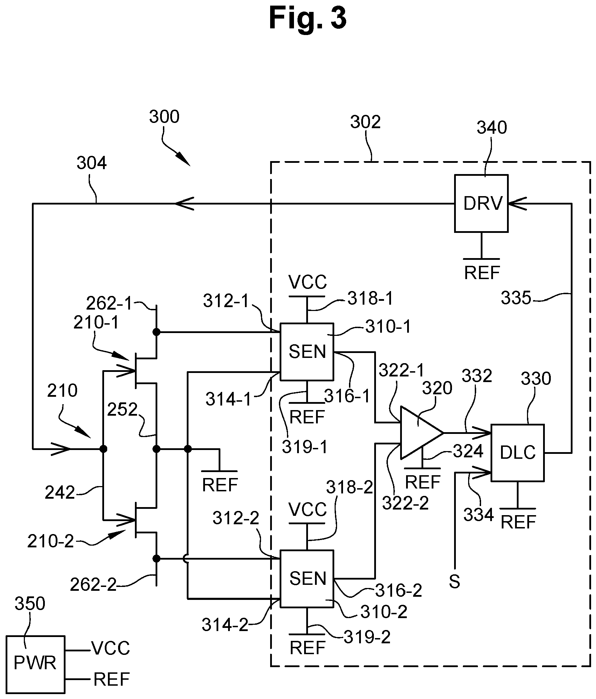

La figure 3 représente, de manière schématique, un mode de réalisation d'un dispositif 300 comprenant un circuit de commande 302 et des interrupteurs électriquement en série commandés par le circuit de commande 302. Un convertisseur tel que décrit en relation avec la figure 1 peut comprendre plusieurs dispositifs 300. Pour chaque dispositif 300, les interrupteurs en série constituent alors, de préférence, un interrupteur bidirectionnel du convertisseur. Par exemple, ces interrupteurs bidirectionnels constituent les interrupteurs respectifs TA1H, TB1H, TA1L et/ou TB1L d'un convertisseur du type du convertisseur 100 de la figure 1. Chaque dispositif 300 reçoit alors un signal de commande S représentatif d'un état souhaité de l'interrupteur concerné. Les signaux de commande S sont alors différents pour les différents dispositifs 300. De préférence, les interrupteurs en série du dispositif 300 sont identiques ou similaires aux interrupteurs 210-1 et 210-2 d'un interrupteur bidirectionnel 200 du type décrit en relation avec la figure 2.

Dans l'exemple représenté, le circuit de commande 302 est relié, de préférence connecté, aux bornes communes 242 et 252 de commande et de source, et aux bornes de drain 262-2 et 262-1. Le circuit 302 fournit une commande 304 appliquée à la borne de commande 242 des interrupteurs 210-1 et 210-2. Dans des variantes, le circuit de commande 302 est relié, de préférence connecté, à des bornes de commande distinctes et aux bornes de conduction des deux interrupteurs. Par bornes de conduction, on entend les bornes mises en conduction l'une avec l'autre à l'état passant du transistor, c'est-à-dire, dans le cas d'un transistor à effet de champ, les bornes de source et de drain. Ainsi, dans une variante, les interrupteurs 210-1 et 210-2 ont des bornes de commande distinctes, et le circuit 302 applique une commande sur chacun des interrupteurs 210-1 et 210-2.

Le circuit de commande 302 comprend, pour chaque interrupteur 210-1, 210-2 un capteur de tension (SEN), respectivement 310-1 et 310-2, adapté à capter, ou mesurer, la tension aux bornes de l'interrupteur concerné. Plus précisément, le capteur 310-1 a des entrées 312-1 et 314-1 reliées, de préférence connectées, aux bornes de conduction de l'interrupteur 210-1. Dans l'exemple représenté, le capteur 310-1 a ses entrées 312-1 et 314-1 reliées, de préférence connectées, respectivement aux bornes de drain 262-1 et de source commune 252. De même, le capteur 310-2 a des entrées 312-2 et 314-2 reliées, de préférence connectées, aux bornes de conduction de l'interrupteur 210-2. Dans l'exemple représenté, le capteur 310-2 a ses entrées 312-2 et 314-2 reliées, de préférence connectées, respectivement aux bornes de drain 262-2 et de source commune 252.

Chaque capteur 310-1, 310-2 est adapté à fournir sur une sortie, respectivement 316-1, 316-2, un signal représentatif de la tension entre bornes de conduction de l'interrupteur. De préférence, ce signal représentatif a la forme d'une tension. A titre d'exemple, le signal fourni par chaque capteur 310 a un niveau variant de façon continue dans une plage, par exemple comprise entre 0 et 3,3 V, ou par exemple comprise entre 0 et 5,5 V, lorsque la tension aux bornes de l'interrupteur considéré varie au cours du fonctionnement du convertisseur.

Le circuit de commande 302 comprend un circuit de comparaison 320. Le circuit de comparaison 320 a deux entrées 322-1 et 322-2 reliées, de préférence connectées, aux sorties respectives 316-1 et 316-2 des capteurs respectifs 310-1 et 310-2. Le circuit de comparaison 320 est adapté à comparer l'un à l'autre les signaux reçus sur ses entrées 322-1 et 322-2. De préférence, le circuit de comparaison est adapté à comparer l'un à l'autre les potentiels sur ses entrées 322-1 et 322-2. Pour cela, le circuit de comparaison est de préférence un comparateur, par exemple de référence commerciale AD8561. En variante, le circuit de comparaison est un amplificateur opérationnel monté en comparateur.

L'un au moins des capteurs 310-1 et 310-2 est un circuit actif. Un capteur est dit circuit actif lorsqu'il a au moins une borne d'alimentation distincte de ses entrées, c'est-à-dire non connectée directement à une des entrées. Par borne d'alimentation, on entend que, en fonctionnement, la borne d'alimentation est reliée, de préférence connectée, à une source d'alimentation 350 (PWR), et le capteur prélève de l'énergie sur la source d'alimentation pour fonctionner sans prélever cette énergie sur les entrées. Ce prélèvement sur la source d'alimentation permet au capteur de fournir sur sa sortie, au moins temporairement, un courant qui peut être supérieur à un courant reçu sur ses entrées. Autrement dit, pour un capteur fournissant une tension, le capteur permet d'adapter l'impédance entre son entrée et sa sortie, c'est-à-dire qu'il présente un rapport entre impédances de sortie et d'entrée inférieur au rapport entre la tension fournie par le capteur et la tension aux bornes de l'interrupteur 210-1, 210-2.

La source d'alimentation 350 fournit une tension continue entre deux noeuds VCC et REF d'application de la tension continue. A titre d'exemple, la tension continue a une valeur égale à environ 3,3 V, par exemple 3,3 V, ou à environ 5 V, par exemple 5 V. Pour cela, à titre d'exemple, la source d'alimentation utilise la tension alternative VAC. La source d'alimentation 350 n'est pas décrite en détail, les modes de réalisation décrits étant compatibles avec les sources d'alimentation usuelles adaptées à fournir des tensions continues utilisées par des circuits d'un convertisseur.

De préférence, les deux capteurs 310-1 et 310-2 sont tous deux des circuits actifs. Ainsi, les capteurs 310-1 et 310-2 ont chacun une première borne d'alimentation, respectivement 318-1 et 318-2, distincte des entrées, respectivement 312-1, 314-1, et 312-2, 314-2, et reliée, de préférence connectée, au noeud VCC. De préférence, le noeud VCC est commun pour les deux capteurs 310-1 et 310-2 et relié, de préférence connecté, à la même source d'alimentation 350. En variante, les noeuds VCC sont distincts pour les deux capteurs 310-1 et 310-2, et les capteurs peuvent alors être reliés à des sources d'alimentation différentes. De préférence, le potentiel du noeud VCC est supérieur à celui du noeud REF.

Les capteurs 310-1 et 310-2 ont chacun une deuxième borne d'alimentation, respectivement 319-1 et 319-2, reliée, de préférence connectée, au noeud REF. De préférence, le noeud REF est commun pour les deux capteurs. En variante, pour des capteurs reliés à des sources d'alimentation différentes, le noeud REF peut être distinct pour les deux capteurs.

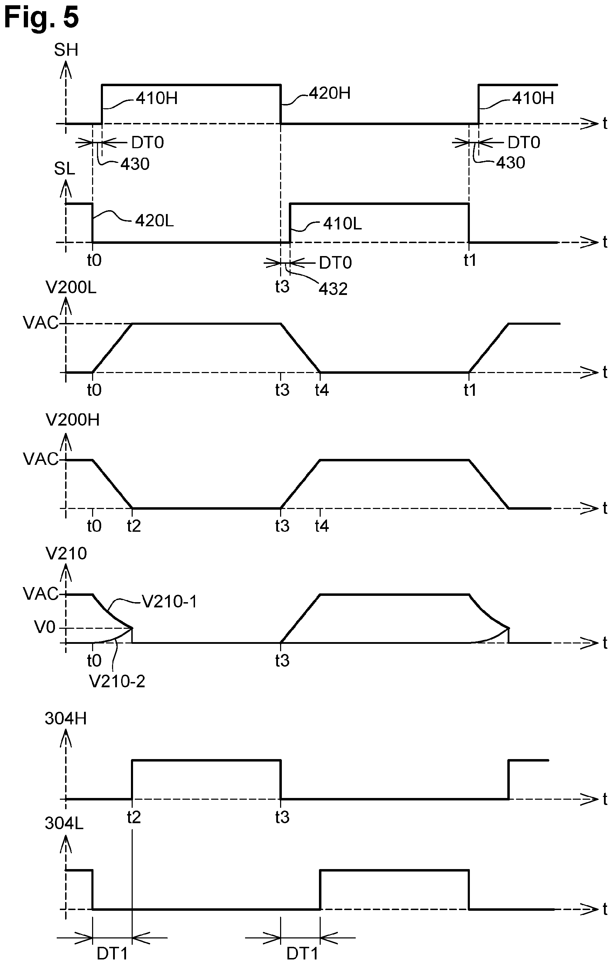

On aurait pu penser utiliser seulement des capteurs passifs, par exemple des capteurs de tension comprenant seulement des résistances, tels que des diviseurs de tension, pour obtenir des signaux à partir des tensions aux bornes des interrupteurs. Ces résistances auraient ralenti la charge d'une capacité parasite à l'entrée du circuit de comparaison 320 et/ou auraient prélevé, de manière permanente, un courant en provenance des bornes des interrupteurs 210-1 et 210-2. En comparaison, le fait de prévoir qu'au moins l'un des capteurs soit un circuit actif permet, pour un même courant d'entrée, de charger la capacité parasite plus rapidement, et/ou permet de réduire le courant prélevé par le capteur sur les bornes des interrupteurs. Le fait de réduire le courant prélevé permet d'augmenter le rendement énergétique du convertisseur. A titre d'exemple, les capteurs ont une impédance d'entrée supérieure à 1 MΩ. Le courant d'entrée des capteurs peut être inférieur à 0,5 mA, voire inférieur à 0,1 mA. En outre, comme ceci est expliqué ci-après en relation avec la figure 5, le fait de charger plus rapidement, la capacité parasite d'entrée du circuit de comparaison, permet également d'augmenter le rendement énergétique du convertisseur.

De préférence, les capteurs sont deux circuits actifs présentant une même relation entre entrée et sortie, c'est-à-dire fournissent un même signal pour une même tension aux bornes des interrupteurs. En fonctionnement, le circuit de comparaison 320 fournit sur sa sortie un résultat de la comparaison entre les tensions aux bornes des interrupteurs 210-1 et 210-2. Ainsi, un changement d'état du résultat fourni par le circuit de comparaison se produit lorsque la tension aux bornes de l'association série des interrupteurs 210-1 et 210-2, autrement dit la tension aux bornes de l'interrupteur bidirectionnel 200, passe par la valeur nulle.

Le circuit de commande 302 comprend en outre un circuit logique 330 (DLC). Le circuit 330 a une entrée 332 reliée, de préférence connectée, à la sortie du circuit de comparaison 320. Le circuit logique 330 reçoit le signal de commande S sur une autre entrée 334. Le circuit logique 330 est adapté à fournir un signal 335, à partir du résultat fourni par le circuit de comparaison et du signal de commande S. De préférence, le circuit de commande 302 comprend en outre un circuit 340 d'attaque, DRV (en anglais "driver") recevant le signal 335 et appliquant, en fonction du signal 335, la commande 304 aux interrupteurs 210-1 et 210-2. En variante, le circuit logique 330 applique directement la commande 304 aux interrupteurs 210-1 et 210-2. Dans une autre variante, le circuit 340 applique, en fonction du signal 335, des commandes distinctes sur des bornes de commande distinctes des interrupteurs. En fonctionnement, les circuits 330 et éventuellement 340 mettent les deux interrupteurs 210-1 et 210-2 à l'état passant lors d'un changement d'état logique de la sortie du comparateur, c'est-à-dire un changement d'état du résultat de la comparaison entre les tensions aux bornes des interrupteurs 210-1 et 210-2.

De préférence, les capteurs 310-1 et 310-2, le circuit de comparaison 320, le circuit logique 330 et l'éventuel circuit 340 sont référencés par rapport au potentiel de la borne de source commune 252. Ceci est obtenu, de préférence, en connectant le noeud REF commun aux capteurs à la borne de source commune 252, et en reliant, de préférence connectant, une borne 324 d'application d'un potentiel bas d'alimentation du circuit de comparaison 320 au noeud REF commun. Plus préférentiellement, les circuits 330 et éventuellement 340 ont également des bornes d'application d'un potentiel bas d'alimentation connectées au noeud REF. En variante, le noeud REF a un potentiel fixe référencé par rapport au potentiel de la borne de source commune 252, c'est à dire un potentiel présentant un écart de potentiel constant avec celui de la borne de source commune. Ce potentiel fixe est par exemple inférieur au potentiel de la borne de source commune 252.

Ainsi, de préférence, les signaux fournis par les capteurs, le résultat de comparaison fourni par le circuit de comparaison 320, et le signal 335 fourni par le circuit logique, sont référencés par rapport au potentiel de la borne de source commune 252. Dans une variante, ces signaux et résultats de comparaison sont référencés par rapport à un ou plusieurs autres potentiels, par exemple celui de l'une des bornes de drain 262-1 et 262-2 des interrupteurs 210-1 et 210-2. Cependant, par rapport à une telle variante, le signal 335 fourni par le circuit logique 330, et la commande 304, sont au niveau de potentiel permettant la commande simultanée des deux interrupteurs 210-1 et 210-2, sans nécessiter d'adaptation de niveau de potentiel. Ceci est d'autant plus avantageux que la tension entre les bornes de drain 262-1, 262-2 et de source 252 prend alternativement, à la fréquence de découpage, les valeurs élevées définies ci-dessus et des valeurs sensiblement nulles par rapport à ces valeurs élevées. On évite alors les difficultés de mise en oeuvre d'une telle adaptation de niveau de potentiel, ainsi que les retards dans l'application de la commande 304 qui résulteraient de l'adaptation de niveau de potentiel.

De préférence, le circuit de commande 302 est un circuit monolithique, par exemple situé dans un même boîtier. Plus préférentiellement, les circuits de commande 302 reliés aux interrupteurs bidirectionnels d'un même pont en H ou d'une même branche de pont en H, sont compris dans un même circuit intégré monolithique, par exemple situé dans un même boîtier. Le circuit intégré comprend ainsi un ou plusieurs, de préférence deux ou quatre, circuits de commande 302. Un tel circuit monolithique présente, par rapport à un circuit non monolithique, l'avantage de pouvoir être connecté ou relié à un interrupteur bidirectionnel, à une branche de pont en H, ou à un pont en H monolithique, d'une manière plus simple et plus rapprochée, donc moins susceptible d'être perturbée par des parasites.

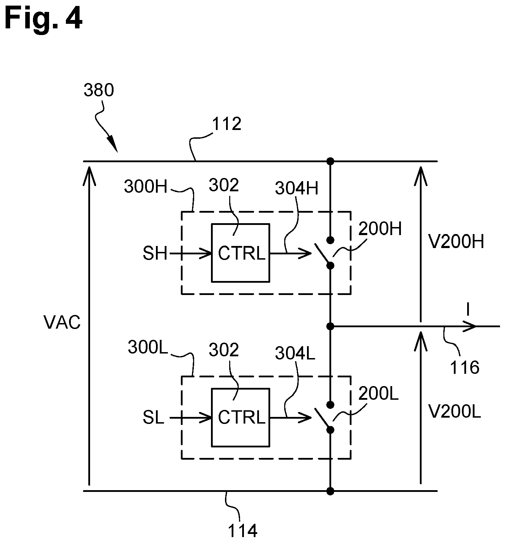

La figure 4 représente, de manière schématique, un mode de réalisation d'une branche 380 de convertisseur comprenant, électriquement en série, un premier interrupteur bidirectionnel 200H, et un deuxième interrupteur bidirectionnel 200L. Dans l'exemple d'un convertisseur tel que celui de la figure 1, la branche 380 peut remplacer la branche 1A et/ou 1B (figure 1). Les premier et deuxième interrupteurs bidirectionnels 200H et 200L constituent alors les interrupteurs respectifs TA1H et TA1L de la branche A1 ou les interrupteurs respectifs TB1H et TB1L de la branche B1. Dans cet exemple, la branche 380 reçoit alors la tension alternative VAC (figure 1) entre les bornes 112 et 114 de la branche. La branche 380 présente des tensions V200H et V200L aux bornes des interrupteurs bidirectionnels respectifs 200H et 200L. La branche 380 fournit un courant I sur un noeud 116 de connexion entre les interrupteurs bidirectionnels 200H et 200L.

Les interrupteurs bidirectionnels 200H et 200L sont, de préférence, chacun constitué par l'interrupteur 200 (figure 3) d'un dispositif respectif 300H, 300L du type du dispositif 300 de la figure 3. Les dispositifs 300H et 300L sont de préférence identiques, à des dispersions de fabrication près. Les dispositifs 300H et 300L sont identiques ou similaires au dispositif 300 de la figure 3, à la différence qu'ils reçoivent des signaux respectifs SH et SL différents l'un de l'autre jouant le rôle du signal S du dispositif 300. En fonctionnement, les circuits 302 (figure 3) de commande (CTRL) des dispositifs 300H, 300L fournissent des commandes respectives 304H et 304L, différentes l'une de l'autre, jouant le rôle de la commande 304 du dispositif 300. Par exemple, les signaux SH et SL sont représentatifs d'états souhaités des interrupteurs respectifs TA1H et TA1L de la branche A1 ou des interrupteurs respectifs TB1H et TB1L de la branche B1. Les signaux SH et SL peuvent être obtenus par tout circuit usuel, non représenté, configuré pour fournir des signaux de commande d'interrupteurs d'une branche de convertisseur. Le potentiel du noeud REF (figure 3) peut en outre être différent dans les dispositifs 300H et 300L.

La figure 5 représente, par des chronogrammes schématiques, un mode de réalisation d'un procédé mis en oeuvre par la branche de la figure 4. Plus précisément, on a représenté, en fonction du temps t, des allures schématiques :
- du signal de commande SH ;
- du signal de commande SL ;
- de la tension V200L aux bornes du deuxième interrupteur bidirectionnel 200L ;
- de la tension V200H aux bornes du premier interrupteur bidirectionnel 200H ;
- de tensions V210 (V210-1 et V210-2) aux bornes respectives des interrupteurs 210-1 et 210-2 (figure 3) dans le premier interrupteur bidirectionnel 200H ;
- de la commande 304H du premier interrupteur bidirectionnel 200H ; et
- de la commande 304L du deuxième interrupteur bidirectionnel 200L.

La durée représentée englobe un cycle de découpage entre deux fronts, par exemple descendants, 420L du signal SL à des instants t0 et t1. Le signal SL comprend, entre les fronts descendants 420L, un front montant 410L. Le signal SH comprend successivement un front montant 410H et un front descendant 420H dans chaque cycle. Le rapport cyclique, défini par le rapport entre le temps pendant lequel le signal SH ou SL est à un niveau donné, par exemple un niveau haut, et le temps d'un cycle de découpage est de préférence égal à environ 0,5, par exemple égal à 0,5. La tension VAC, appliquée aux bornes de la branche (noeuds 112 et 114, figure 4), ne varie pas sensiblement au cours du cycle de découpage.

A la fin du cycle de découpage précédant l'instant t0, le premier interrupteur bidirectionnel 200H est bloqué, et le deuxième interrupteur bidirectionnel 200L est passant. Ceci est obtenu par la mise de la commande 304H à un premier niveau, par exemple un niveau bas, et la mise de la commande 304L par exemple à un niveau haut. La tension V200L est sensiblement nulle, et la tension V200H a sensiblement la valeur de la tension alternative VAC. Dans le premier interrupteur bidirectionnel 200H, la tension alternative VAC est sensiblement appliquée entre drain et source d'un seul des interrupteurs 210-1 et 210-2 (figure 3), par exemple l'interrupteur 210-1. Ainsi, la tension V210-1 a une valeur de l'ordre de celle de la tension alternative VAC, alors que la tension V210-2 est sensiblement nulle.

A l'instant t0, le front 420L du signal SL provoque un changement d'état de la commande 304L et bloque ainsi le deuxième interrupteur bidirectionnel. Le front 410H du signal SH se produit de préférence à la fin d'un délai 430 de durée DT0 débutant à l'instant t0. Pendant le délai 430, les deux signaux SH et SL sont simultanément au niveau bas. Le circuit logique 330 du dispositif 300H reçoit le front montant 410H. Le front 410H provoque, de la manière décrite ci-après, la mise de la commande 304H à un deuxième niveau (par exemple le niveau haut) par le circuit logique 330 après un temps mort DT1 débutant à l'instant t0. Le front 410H constitue ainsi un signal de mise de la commande 304H au deuxième niveau, et peut être remplacé par tout signal de mise de la commande 304H au deuxième niveau. Par temps mort, on entend une période pendant laquelle les premier et deuxième interrupteurs bidirectionnels 200H et 200L sont bloqués simultanément. La durée DT0 est, de préférence, choisie inférieure à la durée du temps mort DT1.

Après l'instant t0, le courant I (figure 4) fourni par la branche 380, par exemple circulant dans une inductance (140, figure 1) décharge l'élément capacitif 118 (figure 1) électriquement en parallèle du premier interrupteur bidirectionnel, et l'élément capacitif 118 en parallèle du deuxième interrupteur bidirectionnel. Dans le premier interrupteur bidirectionnel, chacun des interrupteurs 210-1 et 210-2 (figure 3), à l'état bloqué, se comporte comme un élément capacitif. L'interrupteur 210-1 se décharge et l'interrupteur 210-2 se charge. Tant que la tension V210-1 est supérieure à la tension V210-2, la comparaison entre ces tensions donne le même résultat qu'à l'instant t0. La commande 304H reste au premier niveau, autrement dit, dans le dispositif 300H, le signal 335 (figure 3) fourni par le circuit logique 330 est de sorte que la commande 304H soit maintenue au premier niveau.

A un instant t2, le résultat de la comparaison change. Ceci se produit lorsque les tensions V210-1 et V210-2 sont égales. Les tensions V210-1 et V210-2 ont, à l'instant t2, une valeur commune V0. Pour une valeur de la tension alternative VAC par exemple égale à environ 325 V, la valeur V0 est typiquement de l'ordre de 55 V. Par rapport à une variante dans laquelle le noeud REF a un potentiel fixe négatif référencé par rapport au potentiel de la borne de source commune 252, le fait de prévoir que les capteurs 310-1 et 310-2 et le circuit de comparaison 320 (figure 3) soient alimentés entre le noeud VCC d'application d'un potentiel positif et le noeud REF connecté à la borne de source commune 252, permet de simplifier la comparaison de ces tensions positives.

Dans le dispositif 300H, le circuit logique 330 est configuré pour que, à l'instant t2, le changement d'état de la sortie du circuit de comparaison 320 provoque le passage de la commande 304H au deuxième niveau. Ceci provoque la mise à l'état passant du premier interrupteur bidirectionnel 200H.

Par rapport à un dispositif dans lequel les capteurs ne seraient pas des circuits actifs, le fait que l'un au moins des, de préférence chacun des deux, capteurs 310-1 et 310-2 est un circuit actif, réduit un retard (non représenté) entre l'instant t2 et le passage de la commande 304H au deuxième niveau. En effet, ce retard est, au moins en partie, lié au temps de chargement des capacités parasites d'entrée du circuit de commande. A titre d'exemple, on peut obtenir un retard entre l'instant t2 et la mise à l'état passant du premier interrupteur bidirectionnel 200H inférieur à 25 ns, voire inférieur à 5 ns. Par rapport à un retard plus long, on réduit la possibilité pour la tension aux bornes du premier interrupteur bidirectionnel 200H d'augmenter à nouveau, en valeur absolue, après son annulation à l'instant t2. On minimise ainsi les pertes d'énergie dans l'interrupteur bidirectionnel lors de la commutation.

A titre d'exemple, dans le cas d'un convertisseur AC-DC pour fourniture d'une puissance de 100W au standard USB-PD, on peut obtenir un rendement énergétique de conversion supérieur à 99,2 %, voire supérieur à 99,6 %. En particulier, le convertisseur peut alors présenter un niveau d'échauffement lié aux pertes énergétiques, inférieur à 1,9 W/cm³ (35 W/pouce³). Ceci permet de mettre le convertisseur à l'intérieur d'une prise murale sans avoir de difficulté à évacuer la chaleur produite.

En outre, la réduction du retard entre l'instant t2 et la mise à l'état passant du premier interrupteur bidirectionnel 200H, permet de limiter le niveau d'harmoniques produit par le convertisseur. Ceci facilite la conformité du convertisseur avec des niveaux maxima admissibles de niveau d'harmonique, en particulier lorsque la puissance dépasse environ 70 W.

Après l'instant t2, la commande 304H reste au deuxième niveau jusqu'à un instant t3 auquel le circuit logique 330 (figure 3) reçoit un signal de mise de la commande 304H au premier niveau, ici le front descendant 420H du signal SH. A l'instant t3, la commande 304H passe au premier niveau. Ceci provoque la mise du premier interrupteur bidirectionnel 200H à l'état bloqué à l'instant t3. Le front montant 410L du signal SL a lieu ensuite, à la fin d'un délai 432 débutant à l'instant t3 et ayant, de préférence, la même durée DT0 que le délai 430. De préférence, les tensions V200L et V200H évoluent entre l'instant t3 et un instant t4 de manière similaire aux tensions respectives V200H et V200L entre les instants t0 et t2. Le deuxième interrupteur bidirectionnel 200L est mis à l'état passant (commande 304L mise au niveau haut) à l'instant t4 après une période de temps mort DT1 débutant à l'instant t3, au moment où la tension aux bornes du deuxième interrupteur bidirectionnel a une valeur nulle ou sensiblement nulle. Les tensions V210-1 et V210-2 reviennent aux valeurs sensiblement égales à respectivement VAC et 0 qu'elles avaient avant l'instant t0.

Dans le cycle décrit ci-dessus, les interrupteurs bidirectionnels 200H et 200L sont simultanément à l'état bloqué entre les instants t0 et t2, et entre les instants t3 et t4. On a ainsi obtenu le temps mort DT1. Le fait de prévoir le temps mort DT1 permet d'éviter tout risque de mettre la branche en court-circuit. Un tel court-circuit pourrait endommager le convertisseur et/ou réduire sa fiabilité.

Selon un avantage, le temps mort DT1 ainsi obtenu est à la fois suffisamment long pour réduire le risque qu'un courant circule simultanément dans les deux interrupteurs bidirectionnels de la branche, et suffisamment court pour réduire le risque qu'un courant commence à circuler, par exemple, dans une diode formée par les semiconducteurs de l'un ou l'autre des interrupteurs 210-1, 210-2 composant chacun des interrupteurs bidirectionnels 200H et 200L. De tels courants augmenteraient la consommation énergétique du convertisseur. Le temps mort DT1 obtenu dans le présent mode de réalisation a donc une durée optimale permettant, en même temps, un rendement énergétique particulièrement élevé, et une augmentation de la fiabilité du convertisseur en évitant les risques de court-circuit. Le temps mort DT1 obtenu présente l'avantage supplémentaire de varier lorsque les paramètres de fonctionnement, telles que la tension d'entrée, varient, de sorte que la durée du temps mort DT1 reste optimale pour tous ou la plupart des paramètres de fonctionnement du convertisseur.

Les délais 430 et 432 prévus dans l'exemple ci-dessus permettent également de limiter les risques de court-circuit. La durée DT0 peut être définie en fonction des éléments choisis pour générer le signal et/ou en fonction des propriétés des circuits logiques 330 (figure 3) des dispositifs de commande des interrupteurs bidirectionnels.

Selon un mode de réalisation, les délais 430 et 432 sont omis (en d'autres mots, la durée DT0 est nulle ou sensiblement nulle). Autrement dit, les signaux SH et SL sont inverses l'un de l'autre. On pourra alors, avantageusement, commander les deux interrupteurs bidirectionnels de la branche à partir d'un seul des signaux SH et SL, par exemple correspondant au signal S (figure 3), l'autre des signaux SH et SL étant obtenu au moyen d'un inverseur, par exemple recevant le signal SH et fournissant le signal SL. D'une manière plus générale, les signaux SH et SL peuvent être fournis par tout circuit permettant d'obtenir deux signaux opposés avec un seul signal. Ceci permet d'obtenir les signaux SH et SL de manière particulièrement simple. Dans le cas où le potentiel du noeud REF (figure 3) est différent dans les deux dispositifs 300H et 300L, les signaux SH et SL peuvent être appliqués aux dispositifs respectifs 300H et 300L par tout circuit usuel de transmission des signaux SH et SL entre des circuits référencés à des niveaux de potentiel différents.

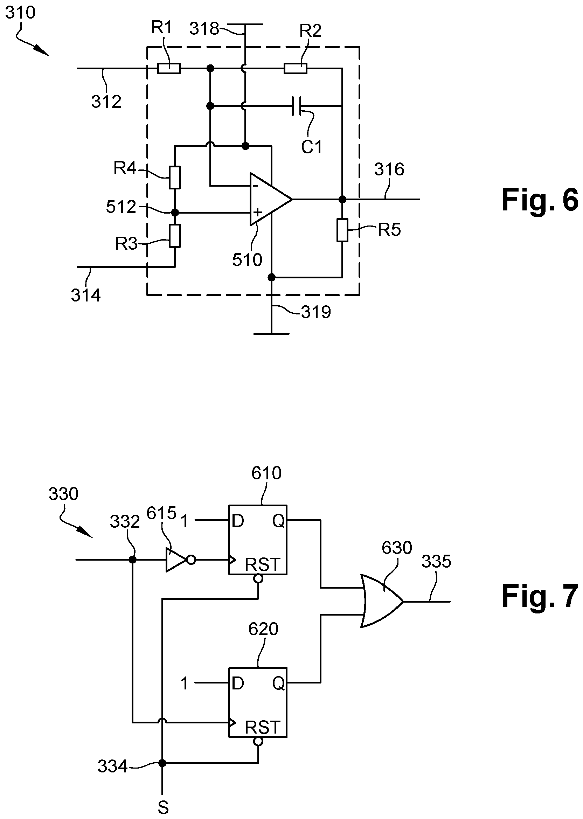

La figure 6 représente, de manière schématique, un mode de réalisation d'un capteur 310. Le capteur 310 peut constituer l'un et/ou l'autre des capteurs 310-1 et 310-2 du circuit de commande 302 de la figure 3.

Le capteur 310 comprend un amplificateur opérationnel 510. L'amplificateur 510 a des bornes d'alimentation reliées, de préférence connectées, aux bornes d'alimentation 318 et 319 du capteur 310. La sortie de l'amplificateur est reliée, de préférence connectée, à la sortie 316 du capteur. A titre d'exemple, l'amplificateur est du type connu sous la référence commerciale OPA859.

Le capteur 310 comprend une première résistance, R1, reliant une entrée inverseuse de l'amplificateur 510 à une entrée 312 du capteur. La résistance R1 a une valeur par exemple de l'ordre de 2,2 MΩ.

Le capteur 310 comprend une deuxième résistance, R2, reliant l'entrée inverseuse de l'amplificateur 510 à une sortie de l'amplificateur 510. La résistance R2 a une valeur par exemple de l'ordre de 500 Ω.

De préférence, le capteur 310 comprend un condensateur C1 électriquement en parallèle de la deuxième résistance R2. A titre d'exemple, la capacité C1 a une valeur de l'ordre de 5 pF à 10 pF. La capacité C1 permet d'améliorer la stabilité du fonctionnement de l'amplificateur 510.

De préférence, le capteur 310 comprend, en outre, une résistance R5 reliant la sortie de l'amplificateur à la borne d'alimentation 319. La résistance R5 a une valeur par exemple de l'ordre de 100 kΩ. La résistance R5 permet d'améliorer la stabilité du fonctionnement de l'amplificateur 510. La résistance R5 peut être omise.

L'amplificateur 510 a une entrée non inverseuse reliée, de préférence connectée, à un noeud 512. Le noeud 512 connecte des résistances R3 et R4 électriquement en série entre une entrée 314 (connectée à la borne de source 252) et la borne 318 (connectée au noeud VCC) . A titre d'exemple, les résistance R3 et R4 ont des valeurs de l'ordre de 1 kΩ. Ainsi, le noeud 512 est un noeud d'application d'un potentiel fixe par rapport à celui de la borne de source 252. De préférence, comme dans l'exemple représenté, ce potentiel est strictement positif.

Dans une variante, les résistances R3 et R4 sont omises, et le noeud 512 est relié, de préférence connecté, à l'entrée 314. Dans cette variante, afin que le signal de sortie du capteur puisse prendre des valeurs négatives, l'amplificateur 510 est alimenté entre un potentiel positif appliqué à la borne 318 et un potentiel négatif appliqué à la borne 319, ces potentiels étant référencés par rapport à celui de la borne de source 252. Cependant, par rapport à une telle variante, le potentiel fixe strictement positif appliqué au noeud 512 provoque un décalage (en anglais "offset") constant dans la relation entre entrée et sortie du capteur. Autrement dit, la tension de sortie du capteur n'est pas nulle lorsque la tension aux bornes de l'interrupteur 210-1, 210-2 concerné est nulle. Ce décalage constant permet d'obtenir une tension de sortie de capteur positive pour toute la plage des valeurs de la tension aux bornes de l'interrupteur concerné 210-1, 210-2. L'amplificateur 510 peut donc être alimenté entre un potentiel positif appliqué à la borne 318 et le potentiel de référence de la borne de source 252. Ainsi, par rapport à un capteur sans décalage constant, le décalage constant permet de simplifier l'alimentation du capteur 310.

Le décalage constant peut être obtenu par tout circuit permettant d'obtenir un décalage constant dans la relation entre entrée et sortie du capteur. En particulier, le noeud 512 peut être tout noeud fournissant un potentiel fixe strictement positif référencé par rapport au potentiel de la borne de source 252. Les noeuds 512 des capteurs 310-1 et 310-2 peuvent être distincts, ou le noeud 512 peut être commun aux capteurs 310-1 et 310-2.

On a décrit ci-dessus un capteur de tension par un exemple particulier de circuit actif. Cet exemple n'est pas limitatif, le capteur de tension pouvant être constitué par tout circuit actif apte à fournir un signal à partir de la tension aux bornes d'un interrupteur.

La figure 7 représente, de manière schématique, un mode de réalisation du circuit logique 330 du dispositif de la figure 3.

Le circuit logique 330 comprend deux bascules 610 et 620 (en anglais "flip-flop"). Chaque bascule a une entrée de donnée (D) recevant un niveau logique haut ("1"). Chaque bascule a une entrée de remise à zéro (RST) connectée à l'entrée 334 du circuit 330. L'entrée de remise à zéro est configurée de sorte que, lorsque le signal reçu sur cette entrée a un niveau bas, une sortie (Q) de la bascule est mise à zéro. La bascule 610 a une entrée de synchronisation, ou d'horloge, reliée, de préférence connectée, à la sortie d'un inverseur 615 dont l'entrée est reliée, de préférence connectée, à l'entrée 332 du circuit 330. La bascule 620 a une entrée de synchronisation reliée, de préférence connectée, à l'entrée 332 du circuit logique 330. Le circuit 330 comprend en outre une porte logique OU 630 ayant une entrée reliée à la sortie (Q) de la bascule 610 et une autre entrée reliée à la sortie (Q) de la bascule 620. La porte logique OU 630 fournit, sur sa sortie, le signal 335.

En fonctionnement, lorsque le signal S est au niveau logique bas, le signal 335 est au niveau logique bas. Lorsque le signal S est au niveau logique haut, le signal 335 reste au niveau logique bas jusqu'à ce qu'un front fourni par le circuit de comparaison 320 arrive sur l'entrée 332. Le front provoque le passage du signal 335 au niveau logique haut. Le signal 335 reste ensuite au niveau logique haut tant que le signal S est au niveau logique haut. Le front peut être montant ou descendant. Le fait de prévoir ce passage du signal 335 au niveau logique haut pour les deux sens, montant et descendant, des fronts permet d'obtenir un fonctionnement similaire à celui décrit en relation avec la figure 5 pour les deux sens de la tension alternative VAC.

Divers modes de réalisation et variantes ont été décrits. L'homme de l'art comprendra que certaines caractéristiques de ces divers modes de réalisation et variantes pourraient être combinées, et d'autres variantes apparaîtront à l'homme de l'art.

Enfin, la mise en oeuvre pratique des modes de réalisation et variantes décrits est à la portée de l'homme du métier à partir des indications fonctionnelles données ci-dessus.

## Revendications

1. Dispositif (300) comprenant un interrupteur bidirectionnel comprenant deux interrupteurs (210-1, 210-2) électriquement en série, et un circuit (302) de commande dudit interrupteur bidirectionnel, le circuit de commande comprenant des capteurs (310-1, 310-2) de tensions aux bornes des interrupteurs et un circuit de comparaison (320) de signaux fournis par lesdits capteurs, l'un au moins desdits capteurs étant un circuit actif,
dans lequel lesdits interrupteurs (210-1, 210-2) comprennent des transistors (T1, T2) à effet de champ de même type ayant une borne commune de source (252),
le circuit de commande étant adapté à fournir une commande (304), en fonction d'un résultat fourni par le circuit de comparaison, à une borne de commande (242) commune auxdits interrupteurs (210-1, 201-2).

2. Dispositif selon la revendication 1, dans lequel le circuit de commande (302) est configuré pour faire passer la commande (304) d'un premier niveau à un deuxième niveau lorsqu'un changement d'état dudit résultat se produit.

3. Dispositif selon la revendication 2, dans lequel le circuit de commande (302) est configuré pour :
- effectuer une réception d'un signal supplémentaire (410H) ;
- maintenir la commande (304) au premier niveau entre ladite réception et ledit changement d'état ; et
- maintenir la commande (304) au deuxième niveau entre ledit changement d'état et une réception d'un autre signal supplémentaire (420H).

4. Dispositif selon l'une quelconque des revendications 1 à 3, dans lequel lesdites tensions sont aux bornes des interrupteurs (210-1, 210-2) respectifs, et lesdits capteurs (310-1, 310-2) sont deux circuits actifs présentant une même relation entre entrée et sortie.

5. Dispositif selon la revendication 4, dans lequel ladite relation comprend un décalage constant.

6. Dispositif selon l'une quelconque des revendications 1 à 5, dans lequel lesdits interrupteurs (210-1, 210-2) sont de type HEMT à GaN.

7. Dispositif selon l'une quelconque des revendications 1 à 6, dans lequel les signaux fournis par lesdits capteurs sont référencés par rapport au potentiel de la borne commune de source (252).

8. Dispositif selon l'une quelconque des revendications 1 à 7, dans lequel chaque capteur (310-1, 310-2) comprend :
- un amplificateur (510) ayant une entrée non inverseuse reliée à un premier noeud (512) d'application d'un potentiel fixe par rapport au potentiel de la borne commune de source (252) ;
- une première résistance (R1) reliant une entrée inverseuse de l'amplificateur à une borne de drain (262-1, 262-2) de l'un desdits transistors (T1, T2) ;
- une deuxième résistance (R2) reliant l'entrée inverseuse à une sortie de l'amplificateur ; et
- de préférence, un condensateur (C1) électriquement en parallèle de la deuxième résistance.

9. Dispositif selon la revendication 8, dans lequel le premier noeud (512) est commun aux capteurs ou les premiers noeuds (512) sont distincts, le ou chaque premier noeud connecte des troisième (R3) et quatrième (R4) résistances électriquement en série entre la borne commune de source (252) et un deuxième noeud (VCC) d'application d'une tension supplémentaire référencée par rapport à la borne commune de source, et, de préférence, l'amplificateur et/ou le circuit de comparaison sont alimentés par ladite tension supplémentaire.

10. Procédé de commande d'un interrupteur bidirectionnel comprenant deux interrupteurs (210-1, 210-2) électriquement en série, mis en oeuvre par un dispositif (300) selon l'une quelconque des revendications 1 à 9, le procédé comprenant la fourniture desdits signaux par lesdits capteurs (310-1, 310-2) et la comparaison desdits signaux l'un à l'autre par ledit circuit de comparaison (320) .

11. Convertisseur à découpage (100) comprenant un ou plusieurs dispositifs (300) selon l'une quelconque des revendications 1 à 9.

12. Convertisseur selon la revendication 11, configuré pour recevoir et/ou fournir une tension alternative (VAC), comprenant deux interrupteurs bidirectionnels (200 ; TA1H, TA1L ; TB1H, TB1L) comprenant chacun les deux interrupteurs (210-1, 210-2) de l'un desdits dispositifs (300), les deux interrupteurs bidirectionnels étant électriquement en série entre deux noeuds (112, 114) d'application de la tension alternative.

## Patentansprüche

1. Eine Vorrichtung (300), die einen bidirektionalen Schalter aufweist, der zwei Schalter (210-1, 210-2) aufweist, die elektrisch in Reihe geschaltet sind, und eine Schaltung (302) zum Steuern des bidirektionalen Schalters, wobei die Steuerschaltung Sensoren (310-1, 310-2) für Spannung über den Schaltern und eine Schaltung zum Vergleichen (320) von Signalen aufweist, die von den Sensoren ausgegeben werden, wobei wenigstens einer der Sensoren eine aktive Schaltung ist,
wobei die Schalter (210-1, 210-2) Feldeffekttransistoren (T1, T2) desselben Typs aufweisen, die einen gemeinsamen Source-Anschluss (252) haben,
wobei die Steuerschaltung in der Lage ist, ein Steuersignal (304) zu liefern, in Abhängigkeit von einem Ergebnis, das von der Vergleichsschaltung ausgegeben wird, an einen Steueranschluss (242), der den Schaltern (210-1, 201-2) gemeinsam ist.

2. Die Vorrichtung nach Anspruch 1, wobei die Steuerschaltung (302) konfiguriert ist zum Schalten des Steuersignals (304) von einem ersten Pegel zu einem zweiten Pegel, wenn eine Zustandsänderung des Ergebnisses auftritt.

3. Die Vorrichtung nach Anspruch 2, wobei die Steuerschaltung (302) konfiguriert ist zum:
- Empfangen eines zusätzlichen Signals (41 0H);
- Halten des Steuersignals (304) auf dem ersten Pegel zwischen dem Empfang und dem Zustandswechsel; und
- Halten des Steuersignals (304) auf dem zweiten Pegel zwischen dem Zustandswechsel und dem Empfang eines anderen zusätzlichen Signals (420H).

4. Die Vorrichtung nach einem der Ansprüche 1 bis 3, wobei die Spannungen über den jeweiligen Schaltern (210-1, 210-2) anliegen und die Sensoren (310-1, 310-2) zwei aktive Schaltungen sind, die eine gleiche Beziehung zwischen dem Eingang und dem Ausgang haben.

5. Die Vorrichtung nach Anspruch 4, wobei die Beziehung einen konstanten Offset aufweist.

6. Die Vorrichtung nach einem der Ansprüche 1 bis 5, wobei die Schalter (210-1, 210-2) vom GaN-HEMT-Typ sind.

7. Die Vorrichtung nach einem der Ansprüche 1 bis 6, wobei die Signale, die von den Sensoren ausgegeben werden, auf das Potential des gemeinsamen Source-Anschlusses (252) bezogen sind.

8. Die Vorrichtung nach einem der Ansprüche 1 bis 7, wobei jeder Sensor (310-1, 310-2) Folgendes aufweist:
- einen Verstärker (510) mit einem nicht-invertierenden Eingang, der mit einem ersten Knoten (512) zum Anlegen eines in Bezug auf das Potential des gemeinsamen Quellenanschlusses (252) festen Potentials gekoppelt ist;
- einen ersten Widerstand (R1), der einen invertierenden Eingang des Verstärkers mit einem Drain-Anschluss (262-1, 262-2) eines der Transistoren (T1, T2) verbindet;
- einen zweiten Widerstand (R2), der den invertierenden Eingang eines Ausgangs des Verstärkers koppelt; und
- vorzugsweise einen Kondensator (C1), der elektrisch parallel zu dem zweiten Widerstand geschaltet ist.

9. Die Vorrichtung nach Anspruch 8, wobei der erste Knoten (512) den Sensoren gemeinsam ist oder wobei die ersten Knoten (512) getrennt sind, wobei der oder jeder erste Knoten dritte (R3) und vierte (R4) Widerstände elektrisch in Reihe zwischen dem gemeinsamen Source-Anschluss (252) und einem zweiten Knoten (VCC) zum Anlegen einer zusätzlichen Spannung verbindet, die auf den gemeinsamen Source-Anschluss bezogen ist, und wobei vorzugsweise der Verstärker und/oder die Vergleichsschaltung mit der zusätzlichen Spannung versorgt werden.

10. Ein Verfahren zur Steuerung eines bidirektionalen Schalters, der zwei Schalter (210 1, 210 2) aufweist, die elektrisch in Reihe geschaltet sind, realisiert durch eine Vorrichtung (300) nach einem der Ansprüche 1 bis 9, wobei das Verfahren das Ausgeben der genannten Signale durch die genannten Sensoren (310-1, 310-2) und den Vergleich der genannten Signale miteinander durch die genannte Vergleichsschaltung (320) aufweist.

11. Schaltwandler (100), der eine oder mehrere Vorrichtungen (300) nach einem der Ansprüche 1 bis 9 aufweist.

12. Der Wandler nach Anspruch 11, der konfiguriert ist zum Empfangen und/oder Ausgeben einer Wechselspannung (VAC), der zwei bidirektionale Schalter (200; TA1H, TA1L; TB1H, TB1L) aufweist, die jeweils die beiden Schalter (210-1, 210-2) einer der Vorrichtungen (300) aufweisen, wobei die beiden bidirektionalen Schalter elektrisch in Reihe zwischen zwei Knoten (112, 114) zum Anlegen der Wechselspannung liegen.

## Claims

1. A device (300) comprising a bidirectional switch comprising two switches (210-1, 210-2) electrically in series, and a circuit (302) for controlling said bidirectional switch, the control circuit comprising sensors (310-1, 310-2) of voltage across the switches and a circuit of comparison (320) of signals output by said sensors, one at least of said sensors being an active circuit, wherein said switches (210-1, 210-2) comprise field-effect transistors (T1, T2) of the same type having a common source terminal (252),
the circuit for controlling being capable of delivering a control signal (304), according to a result output by the comparison circuit, to a control terminal (242) common to said switches (210-1, 201-2).

2. The device according to claim 1, wherein the control circuit (302) is configured to switch the control signal (304) from a first level to a second level when a state change of said result occurs.

3. The device according to claim 2, wherein the control circuit (302) is configured to:
- receive an additional signal (410H);
- maintain the control signal (304) at the first level between said reception and said state change; and
- maintain the control signal (304) at the second level between said state change and a reception of another additional signal (420H).

4. The device according to any of claims 1 to 3, wherein said voltages are across the respective switches (210-1, 210-2), and said sensors (310-1, 310-2) are two active circuits having a same relationship between the input and the output.

5. The device according to claim 4, wherein said relationship comprises a constant offset.

6. The device according to any of claims 1 to 5, wherein said switches (210-1, 210-2) are of GaN HEMT type.

7. The device according to any of claims 1 to 6, wherein the signals output by said sensors are referenced to the potential of the common source terminal (252).

8. The device according to any of claims 1 to 7, wherein each sensor (310-1, 310-2) comprises:
- an amplifier (510) having a non-inverting input coupled to a first node (512) of application of a potential fixed with respect to the potential of the common source terminal (252);
- a first resistor (R1) coupling an inverting input of the amplifier to a drain terminal (262-1, 262-2) of one of said transistors (T1, T2);
- a second resistor (R2) coupling the inverting input of an output of the amplifier; and
- preferably, a capacitor (C1) electrically in parallel with the second resistor.

9. The device according to claim 8, wherein the first node (512) is common to the sensors or the first nodes (512) are distinct, the or each first node connects third (R3) and fourth (R4) resistors electrically in series between the common source terminal (252) and a second node (VCC) of application of an additional voltage referenced to the common source terminal and, preferably, the amplifier and/or the comparison circuit are powered with said additional voltage.

10. A method of controlling a bidirectional switch comprising two switches (210-1, 210-2) electrically in series, implemented by a device (300) according to any of claims 1 to 9, the method comprising the outputting of said signals by said sensors (310-1, 310-2) and the comparison of said signals with each other by said comparison circuit (320) .

11. A switched-mode converter (100) comprising one or a plurality of devices (300) according to any of claims 1 to 9.

12. The converter according to claim 11, configured to receive and/or to output an AC voltage (VAC), comprising two bidirectional switches (200; TA1H, TAlL; TB1H, TB1L) each comprising the two switches (210-1, 210-2) of one of said devices (300), the two bidirectional switches being electrically in series between two nodes (112, 114) of application of the AC voltage.
